# EUROPÄISCHE PATENTSCHRIFT

(11) **EP 2 320 383 B1**
(45) Veröffentlichungstag und Bekanntmachung des Hinweises auf die Patenterteilung: **23.05.2012**
(21) Anmeldenummer: 09450199.6
(22) Anmeldetag: 20.10.2009
(51) Int. Cl.: G07B 15/00, H01L 35/00

(54) **Fahrzeuggerät**
Vehicle device
Appareil de véhicule

(43) Veröffentlichungstag der Anmeldung: 11.05.2011
(73) Patentinhaber: Kapsch TrafficCom AG, 1120 Wien (AT)
(72) Erfinder: Nagy, Oliver, 1190 Wien (AT); Leopold, Alexander, 1100 Wien (AT)
(74) Vertreter: Weiser, Andreas

(56) Entgegenhaltungen:
- WO-A-94/01893
- DE-A1- 19 549 185
- DE-A1-102004 043 812
- DE-A1-102006 035 759
- DE-A1-102008 030 758
- DE-B3-102005 040 236
- US-B1- 7 493 974

## Beschreibung

Die vorliegende Erfindung betrifft ein Fahrzeuggerät für ein Straßenmaut- oder -kommunikationssystem zur Montage in einem Fahrzeug, welches Fahrzeuggerät elektronische Komponenten enthält.

Fahrzeuggeräte mit elektronischen Komponenten für Straßenmautsysteme, sogenannte "onboard-units" (OBUs), werden derzeit von Batterien gespeist, welche den größten Bauteil einer solchen OBU darstellen. Auch wenn der Stromverbrauch einer OBU im Bereich von µW liegt und damit äußerst gering ist, ergibt sich bei einer geforderten Lebensdauer der OBU von über 5 Jahren doch eine Batteriekapazität von 100 mAh oder mehr, was eine entsprechende Größe der Batterien bedingt.

Die Erfindung setzt sich zum Ziel, ein Fahrzeuggerät zu schaffen, das auf platzsparende und zuverlässige Art und Weise energieversorgt ist. Dieses Ziel wird erfindungsgemäß mit einem Fahrzeuggerät mit den Merkmalen des Anspruchs 1 erreicht. Aus der DE 10 2008 030 758A1 ist es an sich bekannt, ein ein Fahrzeugbordnetz durch einen des Sonneneinstrahlung ausgesetzten thermoelektrischen Generator in Fahrzeugenergiezuversorgen.

Die Anmelderin hat erstmals erkannt, daß sich thermischelektrische Generatoren besonders gut für die Energieversorgung von OBUs eignen: Gerade bei Fahrzeugen gibt es regelmäßig große Temperaturschwankungen, welche zur Erzeugung von Temperaturdifferenzen ausgenützt werden können, z.B. zwischen dem Fahrzeuginneren und dem Fahrzeugäußeren oder einer Sonneneinstrahlungs- und einer Abschattungsseite des Fahrzeuggeräts. Mit hilfe der Erfindung kann der thermisch-elektrische Generator nicht nur die Sonneneinstrahlung unter der Scheibe, sondern auch die Kontakttemperatur der Scheibe selbst zur Temperaturdifferenzgewinnung ausnützen. Beispielsweise ist im Winter eine vom Fahrtwind gekühlte Scheibe kalt gegenüber einem beheizten Fahrzeuginnenraum und im Sommer eine von Sonne und Fahrtwind erwärmte Scheibe heiß gegenüber einem klimaanlagengekühlten Fahrzeuginnenraum. Doch auch geringere Temperaturunterschiede, wie sie durch die Tag-/Nacht-Schwankungen der Lufttemperatur und deren zeitverzögerte Auswirkung auf den Fahrzeuginnenraum oder während der Fahrt durch das Passieren von abwechselnden Licht-/Schattenbereichen oder unterschiedlichen Luftschichten auftreten, können auf diese Weise zur Energiegewinnung herangezogen werden. Diese Temperaturdifferenzen sind nach Studien der Anmelderin mehr als ausreichend, um eine OBU autark mit Energie zu versorgen.

Thermisch-elektrische Generatoren der genannten Art können in sehr flacher Form hergestellt werden, z.B. als Halbleiterchips, sodaß sie großflächig an einer Seite des Fahrzeuggeräts angebracht werden können und kein nennenswertes Bauraumvolumen beanspruchen. OBUs gemäß der Erfindung können daher wesentlich flacher gefertigt werden als herkömmliche OBUs mit Batterien oder Akkumulatoren. Da die Lebensdauer der OBU auch nicht mehr durch die Kapazität einer Batterie begrenzt ist, hat die OBU so auch eine theoretisch unbegrenzte Lebensdauer.

Bevorzugt ist der thermisch-elektrische Generator mitsamt den elektronischen Komponenten in einem Gehäuse des Fahrzeuggeräts aufgenommen. Alternativ kann der thermisch-elektrische Generator aber auch in einem von den elektronischen Komponenten abgesonderten eigenen Gehäuse aufgenommen sein.

Bevorzugt hat das Fahrzeuggerät ein flaches Gehäuse und die genannte andere Seite liegt auf der Rückseite des Gehäuses frei. Diese Ausführungsform eignet sich besonders zur direkten Kontaktierung der Scheibe oder zum Aussetzen der einen Seite gegenüber dem Sonnenlicht.

Besonders günstig ist es, wenn in der Montagestellung des Fahrzeuggeräts die genannte eine Seite einer Scheibenlüftung des Fahrzeugs zugewandt ist. Dadurch kann direkt die Austrittstemperatur einer Gebläseheizung oder Klimaanlage des Fahrzeugs zur Temperaturdifferenzgewinnung ausgenützt werden.

Wenn das Fahrzeuggerät ein flaches Gehäuse hat, ist es besonders vorteilhaft, die genannte eine Seite über Lüftungsöffnungen im Gehäuse mit dem Innenraum des Fahrzeugs in Verbindung zu bringen. Die Lüftungsöffnungen können bevorzugt nach unten und damit direkt auf die Luftaustrittsdüsen einer Scheibenlüftung ausgerichtet sein.

Gemäß einer weiteren vorteilhaften Variante der Erfindung ist das Fahrzeuggerät auf die Innenseite der Scheibe aufklebbar. Dies erübrigt aufwendige Montagekonstruktionen für das Fahrzeuggerät und fördert den direkten, vollflächigen Wärmeleitungskontakt zwischen dem thermisch-elektrischen Generator und der Scheibe.

Der thermisch-elektrische Generator ist in der Lage, aus einer an zwei seiner Seiten anliegenden Temperaturdifferenz eine elektrische Energie zu erzeugen. Der thermisch-elektrische Generator ist zumindest ein Seebeck-Element (sog. "umgekehrtes Peltier-Element"), welches sich durch flachen Aufbau und hohen Wirkungsgrad auszeichnet. Bevorzugt weist der thermisch-elektrische Generator eine Gruppe aus einer Vielzahl zusammengeschalteter Seebeck-Elemente auf.

Die im Rahmen der Erfindung ausgenützte Temperaturdifferenz kann an sich in beliebiger Richtung auftreten, d.h. sowohl zwischen einem warmen Fahrzeuginnenraum und einer kalten Scheibe bzw. einer im Schatten liegenden Fahrzeuggerätseite, als auch umgekehrt zwischen einem kalten Fahrzeuginnenraum und einer warmen Scheibe bzw. einer in der Sonne liegenden Fahrzeuggerätseite. Da die Polarität der von einem Seebeck-Element erzeugten Ausgangsspannung von der Richtung der Temperaturdifferenz abhängt, ist es besonders vorteilhaft, dass das Seebeck-Element die elektronischen Komponenten über eine Zwischenschaltung zur Polaritätsumwandlung speist, sodaß Temperaturdifferenzen in beiden Richtungen zur Energieversorgung herangezogen werden können.

Besonders günstig ist es, wenn der thermisch-elektrische Generator mit einem elektrischen Akkumulator zur Pufferung der elektrischen Energie beschaltet ist, sodaß eine kontinuierliche Energieversorgung des Fahrzeuggeräts auch für den Fall gewährleistet werden kann, daß sich zeitweise ein Temperaturausgleich einstellt.

Untersuchungen der Anmelderin haben gezeigt, daß alleine die in den Morgen- und Abendstunden auftretenden Temperaturdifferenzen zwischen Fahrzeuginnenraum und Umgebung, welche auf den verzögerten Temperaturausgleich der tageszeitlichen Temperaturschwankungen zurückzuführen sind, ausreichen, um den Akkumulator immer wieder aufzuladen und im zeitlichen Mittel mehr als ausreichend elektrische Energie für die OBU zu erzeugen. Es genügt dazu sogar ein verhältnismäßig kleiner Akkumulator, bevorzugt ein einfacher Kondensator, welcher besonders geringen Platzbedarf hat.

Die Erfindung wird nachstehend anhand eines in den beigeschlossenen Zeichnungen dargestellten Ausführungsbeispiels näher erläutert. In den Zeichnungen zeigen:
Fig. 1 ein mit einem erfindungsgemäßen Fahrzeuggerät ausgestattetes Fahrzeug im Rahmen eines schematisch dargestellten Straßenmautsystems;
Fig. 2 ein Blockschaltbild des Fahrzeuggeräts von Fig. 1; und
die Fig. 3 und 4 das Fahrzeuggerät von Fig. 2 in perspektivischen Vorder- und Rückansichten in der Montagestellung an einer Scheibe.

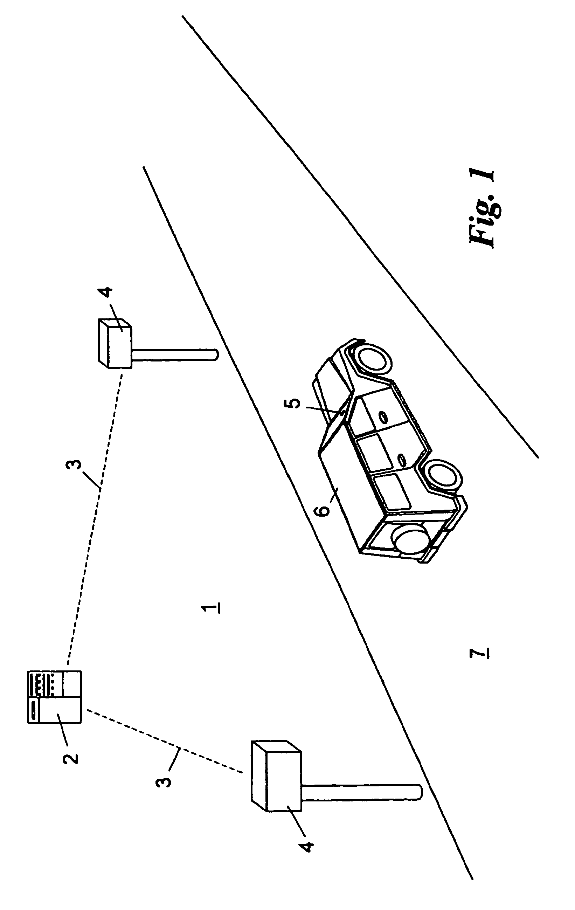

Fig. 1 zeigt ein beispielhaftes und nur ausschnittsweise dargestelltes Straßenmautsystem 1 mit einer Mautzentrale 2, die über ein Datennetz 3, beispielsweise ein Intranet, das Internet oder ein Mobilfunknetz, mit einer Vielzahl von Sendeempfangsstationen 4 in Verbindung steht. Die Sendeempfangsstationen 4 können beliebiger Art sein, beispielsweise straßenseitige Funkbaken nach dem DSRC-Standard (dedicated short range communication Standard) oder WAVE-Standard (wireless access for vehicle environments Standard), oder Basisstationen eines zellularen Mobilfunknetzes, z.B. nach dem GSM-Standard. Über die Sendeempfangsstationen 4 kommuniziert die Mautzentrale 2 mit Fahrzeuggeräten bzw. OBUs 5, die von Fahrzeugen 6 mitgeführt werden, um deren Benutzung von Verkehrsflächen 7 wie Straßen, Autobahnen, Parkplätzen usw. zu vergebühren.

Die OBUs 5 können für die Zwecke der vorliegenden Erfindung von beliebiger Art sein, z.B. sog. "thin clients", welche von Sendeempfangsstationen 4 in Form von z.B. DSRC-Funkbaken lokalisiert werden können, die den Ort der OBU 5 an die Mautzentrale 2 zur Vergebührung melden. Alternativ kann es sich bei den OBUs 5 auch um sog. "thick clients" handeln, welche selbst ihren Ort bestimmen können, beispielsweise durch Identifizieren des Orts der Sendeempfangsstation 4, durch Selbst-Lokalisierung in einem Mobilfunknetz mit Hilfe der Sendeempfangsstationen 4, oder auch mit Hilfe eines eigenen Satellitennavigationsempfängers für ein globales Satellitennavigationssystem (global navigation satellite system, GNSS). Thickclient-OBUs 5 können ihren Ort direkt der Mautzentrale 2 zur Auswertung übermitteln oder mit Hilfe eigener Landkarten gebührenpflichtige Straßensegmente feststellen und ortsanonymisierte Mautdatensätze an die Mautzentrale 2 senden. Thinclient-OBUs 5 senden hingegen in der Regel nur ihre Identifikation an die Sendeempfangsstationen 4, welche daraus Mautdatensätze für die Zentrale 2 erzeugen.

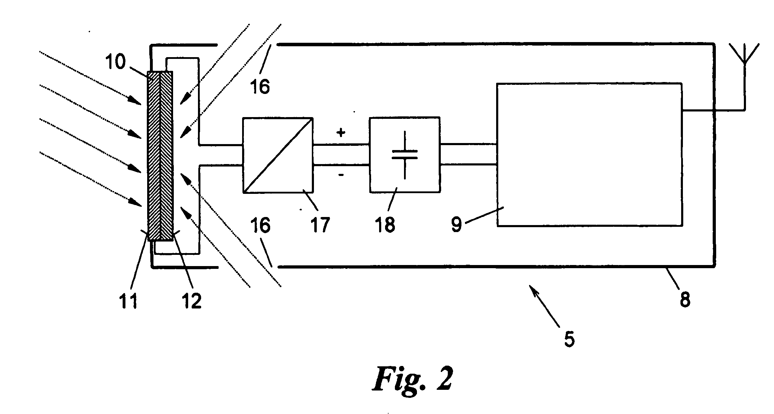

Gemäß Fig. 2 umfaßt die OBU 5 in einem Gehäuse 8 elektronische Komponenten 9, die hier nicht im einzelnen dargestellt sind, wie einen Mikroprozessor, Speicher, Sende- und Empfangseinrichtungen beliebiger Art, z.B. GSM-, DSRC-, WAVE- oder RFID-Kommunikationsmodule, einschließlich deren peripherer Elektronik.

Für die elektrische Energieversorgung der elektronischen Komponenten 9 der OBU 5 ist ein thermisch-elektrischer Generator 10 vorgesehen, der aus einer an zwei (11, 12) seiner Seiten anliegenden Temperaturdifferenz elektrische Energie erzeugen kann. Eine bevorzugte Ausführungsform eines solchen thermisch-elektrischen Generators 10 ist ein Seebeck-Element (sog. "umgekehrtes Peltier-Element") mit flacher Form, an dessen Flachseiten 11, 12 die Temperaturdifferenz anzulegen ist. In einer praktischen Ausführungsform setzt sich ein derartiges Seebeck-Element aus einer Gruppe von mehreren parallel- und/oder seriellgeschalteten "Einzel"-Seebeck-Elementen zusammen.

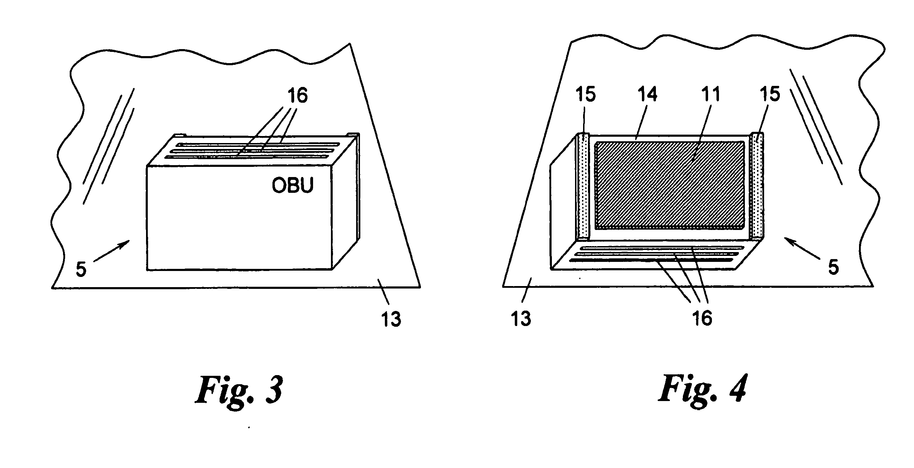

In den Fig. 3 und 4 ist die Montagestellung der OBU 5 an einer Scheibe 13 des Fahrzeugs 6 gezeigt. Die Scheibe 13 ist bevorzugt die Windschutzscheibe des Fahrzeugs 6, es kann sich jedoch auch um jede andere Glas-Scheibe des Fahrzeugs 6 handeln oder sogar um eine nicht aus Glas gefertigte Scheibe, z.B. einen scheibenartigen Teil der Karosserie des Fahrzeugs.

Die Seite 11 des thermisch-elektrischen Generators 10 liegt an der Rückseite 14 des Gehäuses 8 der OBU 5 frei und ist der Scheibe 13 zugewandt, wodurch sie der durch die Scheibe 13 einfallenden Sonneneinstrahlung ausgesetzt ist. Auch wenn die OBU 5 grundsätzlich in einem Abstand zur Scheibe 11 angeordnet werden könnte, wird sie bevorzugt direkt an der Scheibe 13 befestigt. Dadurch kann die Seite 11 des thermisch-elektrischen Generators 10 vollflächig an der Innenseite der Scheibe 13 anliegen, bevorzugt mit Hilfe bzw. unter Zwischenschaltung einer Wärmeleitschicht, z.B. einer wärmeleitenden Folie, Wärmeleitpaste oder eines Wärmeleitkissens, um einen guten Wärmeleitungskontakt zwischen der Scheibe 13 und der Seite 11 herzustellen.

Alternativ kann die OBU 5 und/oder der thermische Generator 10 auch mittels einer lösbaren Halterung an der Scheibe 13 befestigt werden.

Wenn die Scheibe 13 vom metallisierten Typ ist, wird die OBU 5 bevorzugt im Bereich einer Aussparung der Metallisierung auf die Innenseite der Scheibe 13 aufgeklebt.

Zur Befestigung der OBU 5 an der Scheibe 13 kann die Rückseite 14 der OBU 5 mit Klebestreifen 15 versehen werden und/oder die Seite 11 des thermisch-elektrischen Generators 10 und/oder die zwischengeschaltete Wärmeleitpaste selbstklebend ausgeführt werden.

Die andere Seite 12 des thermisch-elektrischen Generators 10 ist dem Innenraum des Fahrzeugs 6 zugewandt, um sie der Innenraumtemperatur des Fahrzeugs 6 auszusetzen. Zu diesem Zweck ist das Gehäuse 8 bevorzugt mit Lüftungsöffnungen 16 ausgestattet. Die Lüftungsöffnungen 16 sind insbesondere so angeordnet, daß sie direkt auf die Luftaustrittsschlitze einer üblichen Scheibenlüftung des Fahrzeugs 6 ausgerichtet werden können, um Heiz- oder Kühlluft einer Heizung bzw. Klimaanlage des Fahrzeugs 6 zu empfangen.

Die an den beiden Seiten 11, 12 des thermisch-elektrischen Generators 10 auftretende Temperaturdifferenz wird vom thermisch-elektrischen Generator 10 in eine elektrische Spannung umgewandelt, deren Polarität von der Richtung und Stärke der Temperaturdifferenz, d.h. dem Temperaturgradienten, abhängt. Der thermisch-elektrische Generator 10 speist die Komponenten 9 daher bevorzugt über eine Zwischenschaltung 17, um aus der temperaturabhängig gepolten Spannung des thermisch-elektrischen Generators 10 eine unipolare Speisepannung zu erzeugen. Die Zwischenschaltung 17 ist beispielsweise ein Gleichrichter. Zusätzlich kann ein elektrischer Akkumulator (Energiespeicher) 18, beispielsweise ein Kondensator mit entsprechender Beschaltung, vorgesehen werden, um die vom thermisch-elektrischen Generator 10 erzeugte elektrische Energie zwischenzuspeichern bzw. zu puffern.

Der thermisch-elektrische Generator ist bevorzugt im selben Gehäuse 8 wie die elektronischen Komponenten 9 angeordnet. Falls gewünscht, könnte der thermisch-elektrische Generator 10 - optional auch die Schaltungskomponenten 17, 18 -auch in einem eigenen, vom Gehäuse 8 und den darin enthaltenen Komponenten 9 abgesonderten eigenen Gehäuse angeordnet und über entsprechende Verbindungsleitungen mit dem Gehäuse 8 und den Komponenten 9 verbunden werden.

Die beschriebenen Fahrzeuggeräte 5 eignen sich auch für andere Zwecke als im Rahmen von Straßenmautsystemen, z.B. als Fahrzeug-Navigationsgeräte, -Boardcomputer, -Kommunikationsgeräte od.dgl. Die Erfindung ist demgemäß nicht auf die dargestellten Ausführungsformen beschränkt, sondern umfaßt alle Varianten und Modifikationen, die in den Rahmen der angeschlossenen Ansprüche fallen.

## Patentansprüche

1. Fahrzeuggerät für ein Straßenmaut- oder -kommunikationssystem zur Montage in einem Fahrzeug, welches Fahrzeuggerät (5) elektronische Komponenten (9) enthält, wobei die elektronischen Komponenten (9) von einem thermisch-elektrischen Generator (10) energieversorgt sind, der aus einer an zwei seiner Seiten (11, 12) anliegenden Temperaturdifferenz elektrische Energie erzeugt, wobei die genannte eine Seite (12) dem Innenraum des Fahrzeugs (6) zugewandt ist, und wobei der thermischelektrische Generator (10) zumindest ein Seebeck-Element ist, **dadurch gekennzeichnet, daß** in der Montagestellung des Fahrzeuggeräts (5) die genannte andere Seite (11) in engen wärmeleitenden Kontakt mit der Innenseite einer Scheibe (13) des Fahrzeugs (6) bringbar ist, bevorzugt in direkte Anlage oder unter Zwischenschaltung einer Wärmeleitschicht, und daß das zumindest eine Seebeck-Element die elektronischen Komponenten (9) über eine Zwischenschaltung (17) zur Polaritätsumwandlung speist.

2. Fahrzeuggerät nach Anspruch 1 für Fahrzeuge (6) mit Scheibenlüftung, **dadurch gekennzeichnet, daß** in seiner Montagestellung die genannte eine Seite (12) der Scheibenlüftung zugewandt ist.

3. Fahrzeuggerät nach Anspruch 1 oder 2, **dadurch gekennzeichnet, daß** der thermisch-elektrische Generator (10) mitsamt den elektronischen Komponenten (9) in einem Gehäuse (8) des Fahrzeuggeräts (5) aufgenommen ist.

4. Fahrzeuggerät nach Anspruch 1 oder 2, **dadurch gekennzeichnet, daß** der thermisch-elektrische Generator (10) in einem von den elektronischen Komponenten (9) abgesonderten eigenen Gehäuse aufgenommen ist.

5. Fahrzeuggerät nach einem der Ansprüche 1 bis 4, **dadurch gekennzeichnet, daß** es ein flaches Gehäuse (8) hat und die genannte andere Seite (11) auf der Rückseite (14) des Gehäuses (8) freiliegt.

6. Fahrzeuggerät nach einem der Ansprüche 1 bis 5, **dadurch gekennzeichnet, daß** es ein flaches Gehäuse (8) hat und die genannte eine Seite (12) über Lüftungsöffnungen (16) im Gehäuse (8) mit dem Innenraum des Fahrzeugs (6) in Verbindung bringbar ist.

7. Fahrzeuggerät nach einem der Ansprüche 1 bis 6, **dadurch gekennzeichnet, daß** es auf die Innenseite der Scheibe (13) aufklebbar ist.

8. Fahrzeuggerät nach einem der Ansprüche 1 bis 7, **dadurch gekennzeichnet, daß** der thermisch-elektrische Generator (10) mit einem elektrischen Akkumulator (18) zur Pufferung der elektrischen Energie beschaltet ist.

9. Fahrzeuggerät nach Anspruch 8, **dadurch gekennzeichnet, daß** der Akkumulator (18) ein Kondensator ist.

10. Fahrzeug (6) mit zumindest einer Scheibe (13) und zumindest einem Fahrzeuggerät nach einem der Ansprüche 1 bis 9, dessen genannte andere Seite (11) in engen wärmeleitenden Kontakt mit der Innenseite der Scheibe (13) gebracht ist, bevorzugt in direkte Anlage oder unter Zwischenschaltung einer Wärmeleitschicht, und dessen genannte eine Seite (12) dem Innenraum des Fahrzeugs (6) zugewandt ist.

## Claims

1. Vehicle apparatus for a road toll or road communication system that is designed for being installed in a vehicle, wherein said vehicle apparatus (5) contains electronic components (9), wherein the electronic components (9) are supplied with energy by a thermal-electric generator (10) that generates electric energy from a temperature difference applied between two of its sides (11, 12), wherein the aforementioned one side (12) faces the interior of the vehicle (6), and wherein the thermal-electric generator (10) is at least one Seebeck element, **characterized in that** the aforementioned other side (11) can be brought into intimate thermally conductive contact with the inside of a windowpane (13) of the vehicle (6), preferably, directly or via an intermediately arranged thermally conductive layer in the installed position of the vehicle apparatus (5), and **in that** the at least one Seebeck element supplies the electronic components (9) with power by means of an intermediate circuit (17) for realizing a polarity reversal.

2. Vehicle apparatus according to Claim 1 for vehicles (6) with windshield ventilation, **characterized in that** the aforementioned first side (12) faces the windshield ventilation in the installed position of the vehicle apparatus.

3. Vehicle apparatus according to Claim 1 or 2, **characterized by** the fact that the thermal-electric generator (10) is accommodated in a housing (8) of the vehicle apparatus (5) together with the electronic components (9).

4. Vehicle apparatus according to Claim 1 or 2, **characterized in that** the thermal-electric generator (10) is accommodated in its own housing that is separated from the electronic components (9).

5. Vehicle apparatus according to one of Claims 1-4, **characterized in that** it has a flat housing (8) and the aforementioned other side (11) is exposed on the rear side (14) of the housing (8).

6. Vehicle apparatus according to one of Claims 1-5, **characterized in that** it has a flat housing (8) and the aforementioned one side (12) can be connected to the interior of the vehicle (6) via ventilation openings (16) in the housing (8).

7. Vehicle apparatus according to one of Claims 1-6, **characterized in that** it can be adhesively attached to the inside of the windowpane (13).

8. Vehicle apparatus according to one of Claims 1-7, **characterized in that** the thermal-electric generator (10) is wired to an electric accumulator (18) in order to buffer the electric energy.

9. Vehicle apparatus according to Claim 8, **characterized in that** the accumulator (18) is a capacitor.

10. Vehicle (6) with at least one windowpane (13) and at least one vehicle apparatus according to one of Claims 1 to 9, the aforementioned other side (11) of which is brought into intimate thermally conductive contact with the inside of the windowpane (13), in particular, directly or via an intermediately arranged thermally conductive layer, and the aforementioned one side (12) of which faces the interior of the vehicle (6).

## Revendications

1. Appareil de véhicule pour un système de péage routier ou un système de communication routier destiné à être monté sur un véhicule, ledit appareil de véhicule (5) contenant des composants électroniques (9), dans lequel les composants électroniques (9) sont alimentés en énergie par un générateur thermique/électrique (10) qui produit une énergie électrique à partir d'une différence de température régnant sur deux de ses côtés (11, 12), dans lequel ledit un des côtés (12) est tourné vers l'habitacle intérieur du véhicule (6) et le générateur thermique/électrique (10) est au moins un élément de Seebeck, **caractérisé en ce que** dans la position de montage de l'appareil de véhicule (5) ledit autre côté (11) peut être amené en contact thermoconducteur intime avec la face intérieure d'une vitre (13) du véhicule (6), de préférence en contact direct ou avec interposition d'une couche thermoconductrice, et **en ce que** ledit au moins un élément de Seebeck alimente les composants électroniques (9) via un circuit intermédiaire (17) pour la conversion de polarité.

2. Appareil de véhicule selon la revendication 1, pour des véhicules (6) avec aération des vitres, **caractérisé en ce que** dans la position de montage, le premier côté (12) précité est dirigé vers l'aération des vitres.

3. Appareil de véhicule selon la revendication 1 ou 2, **caractérisé en ce que** le générateur thermique/électrique (10), ensemble avec les composants électroniques (9), est reçu dans un boîtier (8) de l'appareil (5).

4. Appareil de véhicule selon la revendication 1 ou 2, **caractérisé en ce que** le générateur thermique/électrique (10) est reçu dans un boîtier propre séparé des composants électroniques (9).

5. Appareil de véhicule selon l'une des revendications 1 à 4, **caractérisé en ce qu'**il possède un boîtier plat (8) et **en ce que** l'autre côté précité (11) est dégagé sur le côté arrière (14) du boîtier (8).

6. Appareil de véhicule selon l'une des revendications 1 à 5, **caractérisé en ce qu'**il possède un boîtier plat (8) et **en ce que** le premier côté précité (12) peut être amené en liaison avec l'habitacle intérieur du véhicule (6) via des ouvertures d'aération (16) dans le boîtier (8).

7. Appareil de véhicule selon l'une des revendications 1 à 6, **caractérisé en ce qu'**il est susceptible d'être collé contre la face intérieure de la vitre (13).

8. Appareil de véhicule selon l'une des revendications 1 à 7, **caractérisé en ce que** le générateur thermique/électrique (10) est branché à un accumulateur électrique (18) pour l'accumulation tampon de l'énergie électrique.

9. Appareil de véhicule selon la revendication 8, **caractérisé en ce que** l'accumulateur (18) est un condensateur.

10. Véhicule (6) comprenant au moins une vitre (13) et au moins un appareil de véhicule selon l'une des revendications 1 à 9, dont l'autre côté précité (11) est amené en contact thermoconducteur intime avec la face intérieure de la vitre (13), de préférence en contact direct ou avec interposition d'une couche thermoconductrice, et dont le premier côté précité (12) est tourné vers l'habitacle intérieur du véhicule (6).
